# EUROPEAN PATENT APPLICATION

(11) **EP 2 299 796 A2**
(43) Date of publication of application: **23.03.2011**
(21) Application number: 10177103.8
(22) Date of filing: 16.09.2010
(51) Int. Cl.: H05K 9/00

(54) **A shielding box**

(30) Priority: 18.09.2009 DK 200901040
(71) Applicant: BANG & OLUFSEN A/S, 7600 Struer (DK)
(72) Inventor: Skindhøj Pedersen, Flemming, 7500, Holstebro (DK)
(74) Representative: Hussey, Paul Anthony

(57) **Abstract**

The invention is related to use of shielding boxes on electric PCBs where protection against electromagnetic interference is to be provided. The shielding box has properties that simplify mounting on PCBs and improve the quality of the electromagnetic protection. The shielding box has means providing that it is fixed against the PCB during soldering so that displacement is prevented and so that the box is provided stable full-edged soldering against the PCB after the soldering process. The shielding box is made of sheet metal, and the fixing means of the shielding box are provided by means of precise working by means of laser or chemical etching or electrochemical etching and/or a combination of these processes.

Typical applications for the shielding box are PCBs on which there are mounted equipment like e.g. microprocessors and/or signal processors operating at high speed, and whereby high-frequency signals arise in the form of noise which has to be attenuated efficiently.

## Description

### Technical Field

The invention relates to use of shielding boxes for electric printed circuit boards (PCBs) where protection against electromagnetic interference is to be provided. Typical applications are PCBs on which equipment such as microprocessors and/or signal processors working at high speed are mounted, and whereby high-frequency signals in the form of electromagnetic noise arise.

The shielding box has properties providing that assembly on PCBs is simplified and which improve the quality of the electromagnetic shielding.

### Introduction

Electromagnetic protection of electronic components mounted on PCBs is prior art. A widely used method is application of shielding boxes made of metallic material, e.g. sheet metal. The shielding box is physically mounted on a PCB and is fully soldered in order to provide a design which is immune against electromagnetic irradiation or emitted radiation.

However, there are some inexpedient properties by the prior art:
- The shielding box is difficult to dismount in case of faults occurring on components covered by the shielding box.
- It is difficult to position and retain the shielding box precisely on the PCB during the automatic soldering process by it.
- There is a tendency of the PCB becoming twisted during an automatic soldering process.
- Several costly and complicated processes in connection with punching and bending of the component parts of the shielding box.

An example of known shielding boxes can be seen in US Patent Applications Pub. Nos. 2003/0107881 and 2002/0094721, which use projecting pins which co-operate with holes provided on PCBs for mounting purposes. However, such shielding boxes require precise mounting onto the underlying PCBs, necessitating accurate assembly procedures. Such shielding boxes may also be subject to relative motion between the shielding boxes and the connected PCBs during the assembly process, which may result in inaccurately aligned components post soldering.

It is an object of the invention to provide a shielding box which facilitates ease of assembly, and reduces relative motion of components during assembly.

### Summary of the Invention

Accordingly, there is provided a shielding box for protection against electromagnetic interference for mounting on a PCB, the shielding box comprising at least one mounting portion provided at a lower end of said shielding box, the mounting portion adapted to prevent relative movement between said shielding box and a PCB when said shielding box is mounted on said PCB, said at least one mounting portion comprising:
at least one guide pin; and
at least one pair of retaining pins,
wherein during mounting of said shielding box on a PCB, said at least one guide pin is arranged to engage with at least one wall of an aperture formed on the PCB to guide said mounting portion into said aperture; and wherein during mounting said retaining pins are arranged to act against opposed walls of said aperture to retain said shielding box on said PCB.

As the mounting portions comprise a guide pin element, the mounting portions are more easily inserted into corresponding apertures on an underlying PCB. This makes the assembly operation easier, and reduces the need for relatively costly high-accuracy alignment equipment when implementing an automated assembly process. The retaining pins then act to secure the shielding box to the PCB, to prevent any undesired motion between the components, which improves the accuracy of automated soldering machines.

Preferably, said shielding box further comprises a lining element, wherein said lining element is applied in said aperture to at least a portion of said at least one wall of an aperture formed on the PCB, and wherein said retaining pins are arranged to act against said lining element in said aperture to retain said shielding box on said PCB.

The use of the lining element allows for a more secure mounting of the shielding box to the PCB, as the material of the lining can be chosen to provide a relatively high frictional force between the mounting portion and the lining, compared to the frictional force as a result of the mounting portion acting on a bare fibre wall of a PCB.

It will be understood that the lining may be provided as an insertable member which is placed within an aperture of a PCB, for example prior to the mounting of the shielding box. Alternatively, it will be understood that the lining may be applied as a coating to part of the surface of the PCB. At least to a portion of at least one wall of the aperture defined on the PCB. Such a coating may be also be used for example as protection against corrosion.

In one embodiment, the lining is provided as a milled groove in the PCB. Preferably, said groove is between 0.7-0.9 mm in depth. Preferably, said groove is 0.8 mm in depth.

Preferably, said lining is a copper lining. Alternatively, the lining is a gold lining. Preferably, the gold lining is between 0.01-0.05 µm in depth. Further preferably, the gold lining is 0.03 µm in depth.

Preferably, said mounting portion comprises first and second guide pins projecting from said lower edge of said shielding box at opposed ends of said mounting portion.

The use of guide pins at either end of the mounting portion allows for increased chance of success for the insertion operation.

Preferably, said at least one pair of retaining pins are located between said first and second guide pins.

As the retaining pins are provided between the guide pins, then as the mounting portion is inserted into a PCB aperture, the guide pins will engage with the walls of the aperture first to facilitate relatively easy insertion of the mounting portion, before the retaining pins come into contact with the remaining walls of the aperture, to secure the mounting portion, and consequently the shielding box, in position on the PCB.

Preferably, said mounting portion is arranged such that said retaining pins are provided spaced along the length between said first and second guide pins.

As the two retaining pins are provided at spaced-apart locations in between the first and second guide pins, the stability of the mounting portion is improved, and the forces used to secure the shielding box to a PCB are more evenly distributed about the aperture which receives the mounting portion. Furthermore, such a configuration allows for easier construction of the mounting portion, as the retaining pins may be formed (e.g. stamped out or etched) from a single piece of sheet metal.

Preferably, said retaining pins comprise a free end, the retaining pins arranged so that said free ends project in an upward direction towards said lower end of said shielding box.

The free ends project up towards the lower end of the shielding box. As the free ends frictionally engage the walls of the PCB aperture, as the free ends face upwards, this allows for the mounting portion to be easily inserted into the aperture, but requires considerably more force to remove the mounting portion from the aperture. The retaining pins act as a non-return mechanism or ratchet.

Preferably, said retaining pins are arranged so that the free ends of the retaining pins are provided adjacent said lower end of said shielding box.

The retaining pins are arranged such that the free ends of the pins are close to the lower end of the shielding box. In this manner, the free ends of the pins only engage with the walls of the aperture once the mounting portion has been substantially inserted into the aperture. This allows for initial re-adjustment of the positioning of the shielding box on the PCB if required, before the relatively stiff engagement of the free ends of the retaining pins engages with the aperture walls.

Preferably, said free ends of said retaining pins are arranged to frictionally engage with the walls of the aperture of the PCB.

Preferably, said retaining pins are arranged such that the retaining pins are substantially provided at opposed sides of the plane extending between said first and second guide pins.

As the pins are located on either side of the longitudinal axis of the mounting portion, the pins will therefore engage with opposed walls of the PCB aperture. Preferably, the mounting portion is arranged so that, during mounting, said at least one guide pin engages with a first wall of an aperture formed on the PCB and said at least one pair of retaining pins act against opposed second and third walls of said aperture, wherein said second and third walls are orthogonal to said first wall. This provides improved stability of the mounting portion on the PCB, and helps to prevent any movement between the shielding box and the PCB when coupled together.

Preferably, said mounting portion comprises a brace element extending between the lower ends of said first and second guide pins.

The brace element helps to reinforce the guide pins, and increases the stability of the mounting portion as a whole.

Preferably, said retaining pins project from said brace element between said first and second guide pins.

If the brace element is used, the retaining pins may project from the brace element, reducing the materials used to construct the mounting portion.

Alternatively, said retaining pins comprise a pair of substantially U-shaped pins, said pins projecting from said lower edge of said shielding box between said first and second guide pins.

Preferably, said at least one pair of retaining pins are adapted to deflect relative to one another.

Preferably, during mounting said at least one pair of retaining pins are biased against said opposed walls of said aperture.

Preferably, the shielding box comprises a plurality of mounting portions, said mounting portions arranged on opposed lower ends of said shielding box.

As more mounting portions are used, the stability of the mounting of the shielding box to the PCB improves.

Preferably, said mounting portions are provided in opposed pairs about the lower edges of said shielding box.

Preferably, the shielding box further comprises a releasably mounted cover portion.

Preferably, said shielding box is formed from a ductile material.

Preferably, said shielding box is formed from sheet metal having a thickness of between 0.2 - 0.4 mm.

Preferably, said shielding box is formed from sheet metal of nickel silver.

Preferably, said shielding box is formed from sheet metal, and said at least one mounting portion is formed by action of laser, a chemical etching process, an electrochemical etching, or a combination of these processes.

Preferably, said at least one pair of retaining pins are expanded by a bending of the work piece laid into a die.

Preferably, said shielding box is adapted to be soldered along all edges that are in contact with the PCB, a full-edged soldering making the shielding box completely tight against electromagnetic irradiation and/or other emitted electromagnetic radiation.

It will be understood that the mounting portions may comprise a plurality of retaining pins (i.e. more than two), in order to improve the mounting performance of the device.

The invention is very well suited for mass production of PCBs where high quality is required. A particular advantage is achieved by mounting on small, but very compact PCBs, e.g. a system PCB containing microprocessors, signal processors, ASICs and SMD components, and components implemented on the PCB, like paste, film or similar. On this type of PCB it is to be avoided that the PCB is subjected to twisting/bending during mounting of the shielding box.

Qualities achieved by the present invention are:
- The emitted electromagnetic field radiation is minimised and immunity against radiation coming from outside is maximised.
- Mounting of the electromagnetic protection is performed automatically and positioning and fixing the shielding box is performed with great accuracy.

The characteristics of the invention can be summed up to:
- a shielding box made of sheet material which is easy to work;
- a shielding box with self-adjusting positioning on the PCB during mounting and soldering;
- a shielding box which is fixed on the PCB by simple means during mounting and soldering;
- a shielding box which is fully soldered on the PCB so that an efficient electromagnetic protection is achieved;
- a shielding box which may be partially dismounted in order to provide access for component replacement.

In a preferred implementation of the invention there is provided:
a shielding box for protection against electromagnetic interference and made from sheet metal and being self-adjusting in relation to the x,y,z plane of the printed circuit board PCB, and where the fixing means of the shielding box are **characterised in that**
   - one or more fixing pins project on at least to mutually opposite sides of the edges of the shielding box;
   - fixing pins in pairs form part of a group, and for each group of fixing pins, the PCB is provided a hole receiving one or more fixing pins when the shielding box is moved against the PCB;
   - one or more fixing pins are provided expanding properties such that at least two fixing pins may be displaced in relation to each other;
   - one or more of the expanding fixing pins have retaining properties so as to retain the shielding box against the PCB;
   - the shielding box is fixed such that a full-edged soldering can be performed automatically.

The primary means contributing to positioning and fixing are guide pins and fixing pins, respectively, which in a preferred implementation are so that:
- one or more guide pins project on at least two mutually opposite sides of the edges of the shielding box;
- each guide pin may be inserted into a copper lining which is laid into a hole in the PCB;
- each fixing pin provides friction against a copper lining which is laid into a hole in the PCB, where the friction provides retention that retains the shielding box when the box is in contact with the PCB;
- the expanding fixing pins of the shielding box are made as part of one or more guide pins.

The shielding box may be made of sheet metal. In a preferred implementation, the shielding box is made of the material nickel silver, also known as German silver, which has a number of properties making this material particularly suitable:
- It is a very stable material with regard to corrosion, e.g. no rust formation;
- does not require special finishing of the edges;
- can be soldered and has great resiliency in the worked fixing pins.

In order to facilitate access for fault detection and replacement of components covered by the shielding box, part of the latter can be dismounted without breaking the edge soldering. The dismounted part may subsequently be re-established entirely or portly.

In a preferred implementation where the shielding box is made of the material German silver, further advantages are achieved in the production process of the geometry of the shielding box:
- Fixing pins and/or guide pins can be made by standard processes and equipment such as laser action, a chemical etching process, an electrochemical etching, or a combination of these processes.
- The processes are controlled automatically on the basis of a film/mask generated on a CAD system.
- The fixing pins of the shielding box are expanded by simple bending, folding, twisting or a combination of the said processes. Bending may be performed by means of a punch which bends from both sides with the work piece laid into a die.

Standard equipment is used, making the production of the shielding box relatively cheap; this is also the case with prototype items which are produced early in a project stage.

Standard robot equipment is used in the mounting stage where a shielding box is placed on the PCB and fixed to the PCB by a pressure in direction perpendicularly to or approximately perpendicularly to the x, y plane (10) of the PCB.

Guide pins ensure correct positioning and fixing pins ensure that the shielding box is secured at the correct position such that the PCB is ready for an automatic soldering process. All edges in contact with the PCB are soldered, a full-edged soldering making the shielding box completely tight against electromagnetic irradiation and/or other emitted electromagnetic radiation. The shielding box provides maximum protection against high-frequency signals in GHz range.

There is further provided a method of manufacture of a shielded PCB assembly, the method comprising the steps of:
providing a shielding box having at least one mounting portion comprising at least one guide pin and at least one pair of retaining pins; and
mounting said shielding box to a surface of a PCB, said PCB having at least one aperture defined thereon, wherein said at least one mounting portion is guided into said at least one aperture using said at least one guide pin, and wherein said retaining pins act against opposed walls of said aperture to retain said shielding box on said PCB.

As the guide pin acts to guide the mounting portion into the aperture, the ease of the mounting operation is increased, as the shielding box self-aligns itself with the apertures of the PCB.

Preferably, the method further comprises the steps of:
applying a lining element to opposed walls of said aperture, and wherein said retaining pins act against said lining element to retain said shielding box on said PCB.

The use of a lining (or lining element) allows for an increased frictional support between the shielding box and the PCB, increasing the mounting strength.

Preferably, said step of applying comprises inserting at least one lining member into said aperture. Alternatively, said step of applying comprises coating at least a portion of said aperture with a lining material.

Preferably, the method further comprises the step of soldering at least a portion of the edges of the shielding box to the PCB.

### Detailed Description of the Invention

Embodiments of the invention will now be described, by way of example only, with reference to the accompanying drawings, in which:
Fig. 1 is a perspective view of a shielding box according to the invention;
Fig. 2(A) is a front profile view of a first embodiment of a mounting portion of a shielding box according to the invention;
Fig. 2(B) is a side profile view of the mounting portion of Fig. 2(A);
Fig. 3(A) is a front profile view of a second embodiment of a mounting portion of a shielding box according to the invention;
Fig. 3(B) is a side profile view of the mounting portion of Fig. 3(A);
Fig. 4(A) is a cross-sectional view of a mounting potion of a shielding box according to the invention when mounted to a PCB;
Fig. 4(B) is a bottom plan view of a mounting potion of a shielding box according to the invention when mounted to a PCB;
Fig. 5(A) shows an enlarged view of a section of a shielding box according to the invention;
Figs. 5(B)-(D) illustrate sample dimensions of portions of a mounting portion of the shielding box of Fig. 5(A);
Fig. 6 is an enlarged photograph of a mounting portion of a shielding box according to the invention; and
Fig. 7 is an enlarged photograph of the mounting portion of Fig. 6 when mounted to a PCB.

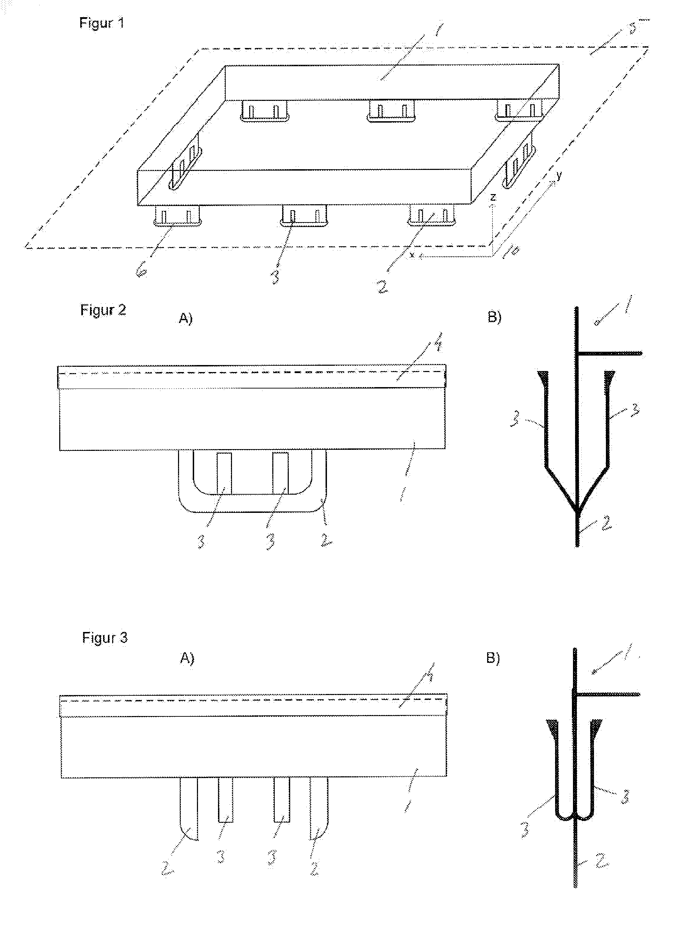

Figure 1 shows in perspective view the principle of the invention. A shielding box (1) is mounted on a PCB (5). Guide pins (2) position the shielding box (1) exactly on the PCB (5) in that guide pins (2) are inserted in copper linings (6) which are laid in punch holes on the PCB. Fixing pins (3) retain the shielding box (1) when it is pressed onto the PCB (5).

The shielding box can be made of sheet metal with thickness from 0.2 mm to 0.4 mm. The material can be chosen among various alternatives, as e.g. sheet metal, phosphated bronze and stainless steel. In a preferred implementation, German silver (also known as nickel silver) with thickness about 0.3 mm is used. Standard alloys of German silver are used, containing copper (45-70%), nickel (8-20%) and zinc (8-45%). The material provides advantageous spring action in the expanding fixing pins.

By the contact between a fixing pin (3) and the copper lining (6) is achieved a retaining property which is caused by the resilient and expanding function of the fixing pin (3) coming from its shape and material and by the pressure applied as the shielding box is pressed against the PCB, i.e. when the fixing pins (3) and the guide pins (2) are pressed down into the copper linings (6). In a preferred implementation, the copper linings are provided as a 0.8 mm milled groove in the PCB. Optionally, the copper lining can be applied a thin layer of gold, typically 0.03 µm, as protection against corrosion.

By mounting the shielding box (1), it is pressed against the PCB (5) with a pressure e.g. of 10 Nm, thus fixing the shielding box such that an automated soldering can be performed. The insertion force runs as an analogue S-curve in the phases: 1) insertion, 2) pin at the bottom, and 3) contact with PCB.

The pull-off force progresses as a steep curve. The pull-off force is greater than the insertion force and is typically 20 Nm.

By the insertion, irregularities/deformations between shielding box edges and PCB are equalised. There is used a solder paste height of < 100 µm, distributed as 50 µm flush/paste and 50 µm tin.

A full-edged soldering may be performed when there are copper strips along all edges of the shielding box.

Figure 2 shows the guide pins (2) and fixing pins (3) of the shielding box (1). Both types of pins are objects that project from the edge of the shielding box. The pins may be produced by methods known within mechanical working, e.g. punching, chemical etching and laser cutting, or similar. By compact system boards with associated small shielding boxes, chemical etching with acid is the most suitable process.

Fig. 2(A) shows a plan view of a first type of mounting portion, with Fig. 2(B) shown a corresponding cross-sectional view. In this embodiment of mounting portion, the guide pins (2) are part of a U-shaped bracket which extends beneath the lower end of the shielding box (1). The retaining or fixing pins (3) project from the lower end of the U-shaped bracket, which acts as a brace between the guide pins. The retaining pins (3) extend in an upwards direction, such that the free ends of the pins (3) are located close to the lower end of the shielding box (1).

Fig. 3(A) shows a plan view of a second type of mounting portion, with Fig. 3(B) shown a corresponding cross-sectional view. In this embodiment of mounting portion, the guide pins (2) project from the lower end of the shielding box (1) at either side of the mounting portion. The retaining or fixing pins (3) project from the lower end the shielding box (1), between the guide pins (2). As can be seen from Fig. 3(B), the retaining pins have a substantially U-shaped profile, such that the free end of either pin (3) projects in an upwards direction substantially towards the shielding box (1).

Figs. 2(B) and 3(B) illustrate that the retaining pins (3) project on either side of the centreline of the mounting portion. This allows for the mounting portion to obtain a secure fit when mounted to a PCB.

Figure 2A shows the shielding box (1) mounted with removable lid (4). After mounting and soldering of the shielding box, the lid may be dismounted when there is a need for test/repair of electronic components covered by the shielding box. The lid may be re-mounted after being dismounted. The pull needed for dismounting the lid (4) is to be adapted to the strength of the edge soldering and the retaining pressure possessed by the fixing pins of the box such that the box is not pulled off its fixed position.

Figure 2B shows how a guide pin (2) can be an extension of the shielding box edge (1) and how fixing pins (3) are bent out and into shape such that a resilient property is achieved as well as a retaining function by the contact between the pins and the copper lining when the pins are inserted into these.

Figure 3 shows an alternative implementation of guide pins (2) and fixing pins (3). Fixing pins may be part of the guide pin object (2A) or they may be independent objects (3A) that appear on the edge (1) of the shielding box. The resilient properties of fixing pins may be achieved with different embodiments of the pins (3B).

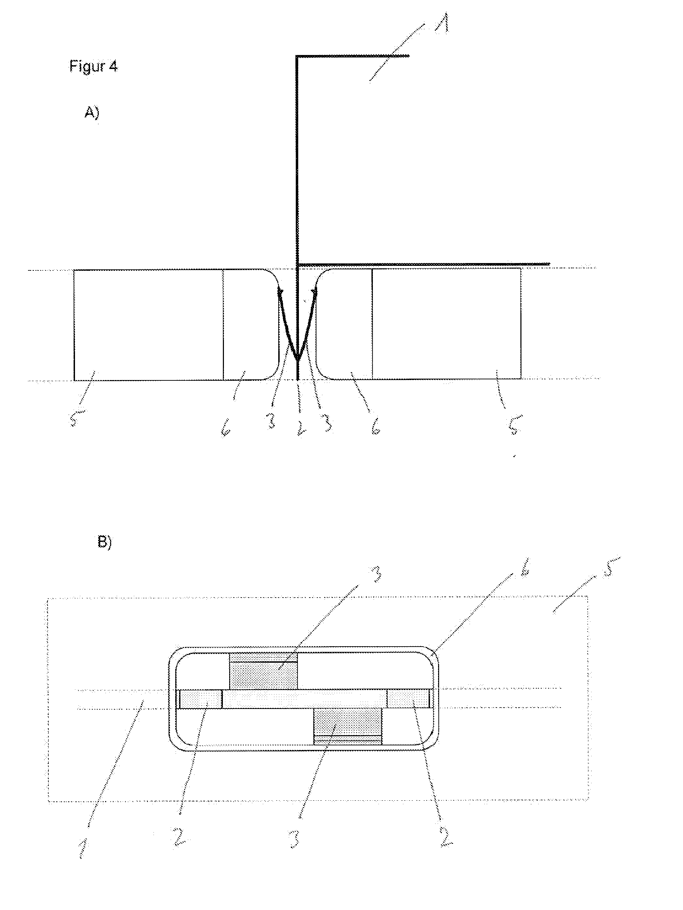

Figure 4A shows in a cross-section the PCB (5) having a copper lining (6) in which a guide pin (2) is inserted, and where fixing pins (3) retain the shielding box (1).

Figure 4B shows the back side of a PCB (5) which has a copper lining (6) in which a guide pin (2) is inserted, and where fixing pins (3) retain the shielding box (1).

The free ends of the retaining pins (3) act to frictionally engage the walls of the aperture. Furthermore, the guide pins (2) may also contribute to the fixing of the mounting portion in position on the PCB.

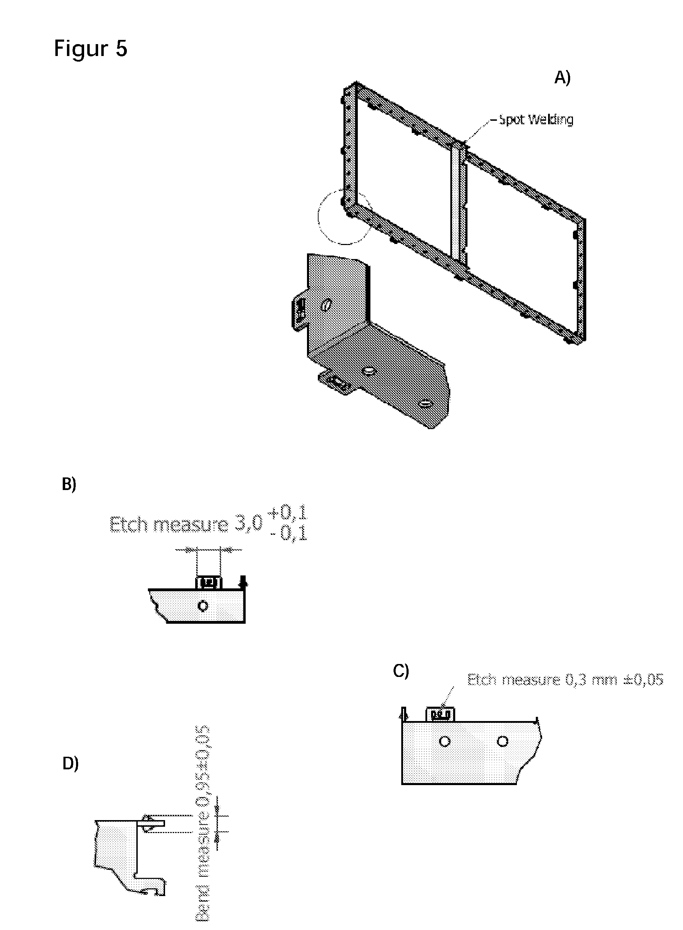

Figure 5 shows details of guide pins and fixing pins. In a preferred implementation, where the material is German silver of 0.3 mm thickness, the typical values are:
- Figure 5A shows a detail of a shielding box; at the edges of a corner is shown two sets of pins, each with guide pins and fixing pins.
- Figure 5B shows the width of a guide pin being 3.0 mm ± 0.1 mm.
- Figure 5C shows the spacing between the etched fixing pins being 0.3 mm ± 0.05 mm.
- Figure 5D shows the spacing between two expanding fixing pins being 0.95 mm ± 0.05 mm.

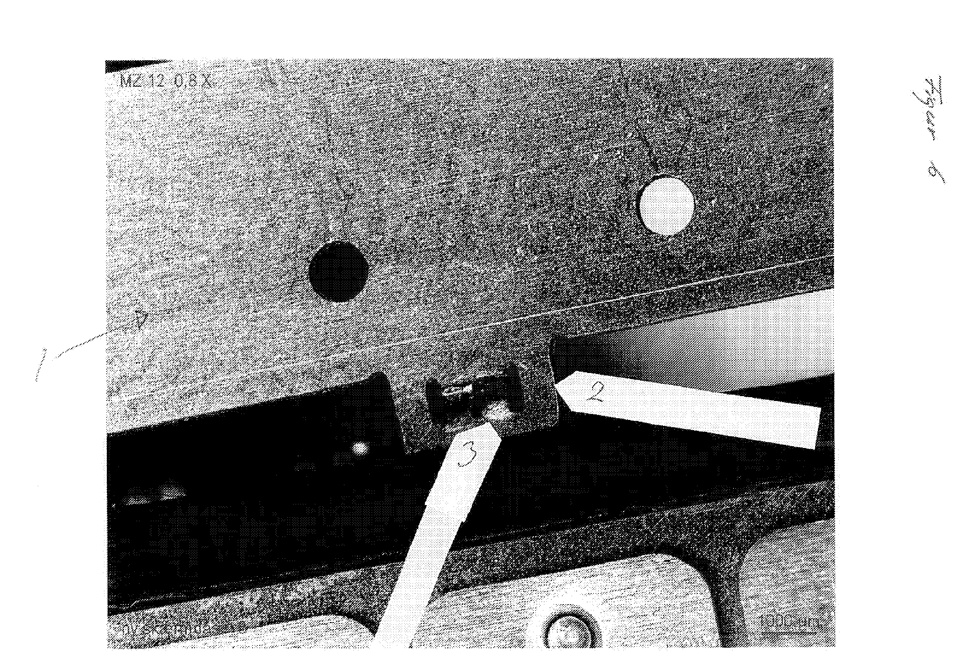

Figure 6 shows a photo before mounting on a PCB. The edge (1) of the shielding box has a guide pin (2) with two integrated fixing pins (3) which are part of the guide pin object.

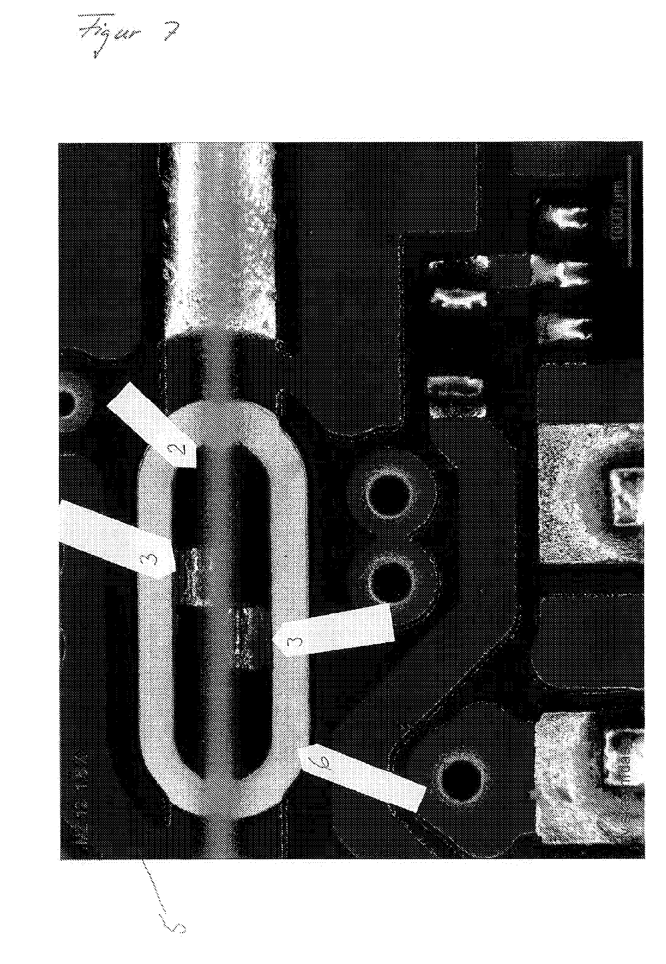

Figure 7 shows a photo after mounting on a PCB. The back side of a PCB (5) is provided with copper lining (6) in which a guide pin (2) is inserted, and where fixing pins (3) retain the shielding box.

The invention has many applications. It is particularly suited for use on PCBs that are to be minimised in size and having great degree of complexity in the implemented electronic circuits, and which furthermore operate at high speeds.

Typical examples, but not limited to such, are: system PCBs containing microprocessors, signal processors, dedicated chipset, ASICs, and high-speed network technology as Wi-Fi, Bluetooth and Ethernet, and telecommunication technology in mobile phones.

The invention is not limited to the embodiments defined herein, but may be amended or altered without departing from the scope of the claimed invention.

## Claims

1. A shielding box for protection against electromagnetic interference for mounting on a PCB, the shielding box comprising at least one mounting portion provided at a lower end of said shielding box, the mounting portion adapted to prevent relative movement between said shielding box and a PCB when said shielding box is mounted on said PCB, said at least one mounting portion comprising:
at least one guide pin; and
at least one pair of retaining pins,
wherein during mounting of said shielding box on a PCB, said at least one guide pin is arranged to engage with at least one wall of an aperture formed on the PCB to guide said mounting portion into said aperture; and wherein during mounting said retaining pins are arranged to act against opposed walls of said aperture to retain said shielding box on said PCB.

2. The shielding box of claim 1, wherein said shielding box further comprises a lining element, wherein said element portion is applied in said aperture to at least a portion of said at least one wall of an aperture formed on the PCB, and wherein said retaining pins are arranged to act against said lining element in said aperture to retain said shielding box on said PCB.

3. The shielding box of claim 1 or claim 2, wherein said mounting portion comprises first and second guide pins projecting from said lower edge of said shielding box at opposed ends of said mounting portion.

4. The shielding box of claim 3, wherein said at least one pair of retaining pins are located between said first and second guide pins.

5. The shielding box of claim 3 or claim 4, wherein said retaining pins comprise a free end, the retaining pins arranged so that said free ends project in an upward direction towards said lower end of said shielding box.

6. The shielding box of claim 5, wherein said retaining pins are arranged so that the free ends of the retaining pins are provided adjacent said lower end of said shielding box.

7. The shielding box of any one of claims 5-6, wherein said free ends of said retaining pins are arranged to frictionally engage with the walls of the aperture of the PCB.

8. The shielding box of any one of claims 5-7, wherein said retaining pins are arranged such that the retaining pins are substantially provided at opposed sides of the plane extending between said first and second guide pins.

9. The shielding box of any one of claims 2-8, wherein said mounting portion comprises a brace element extending between the lower ends of said first and second guide pins.

10. The shielding box of claim 9, wherein said retaining pins project from said brace element between said first and second guide pins.

11. The shielding box of any one of claims 2-8, wherein said retaining pins comprise a pair of substantially U-shaped pins, said pins projecting from said lower edge of said shielding box between said first and second guide pins.

12. The shielding box of any preceding claim, wherein the shielding box comprises a plurality of mounting portions, said mounting portions arranged on opposed lower ends of said shielding box.

13. The shielding box of any preceding claim, wherein the shielding box is made from sheet metal, and wherein said at least one guide pin and/or said at least one pair of retaining pins are made by action of laser, a chemical etching process, an electrochemical etching, or a combination of these processes.

14. A method of manufacture of a shielded PCB, the method comprising the steps of:
providing a shielding box having at least one mounting portion comprising at least one guide pin and at least one pair of retaining pins; and
mounting said shielding box to a surface of a PCB, said PCB having at least one aperture defined thereon, wherein said at least one mounting portion is guided into said at least one aperture using said at least one guide pin, and wherein said retaining pins act against opposed walls of said aperture to retain said shielding box on said PCB.

15. The method of claim 14, wherein the method further comprises the steps of:
applying a lining element to opposed walls of said aperture, and wherein said retaining pins act against said lining element to retain said shielding box on said PCB.
